# EUROPEAN PATENT APPLICATION

(11) **EP 2 662 885 A1**
(43) Date of publication of application: **13.11.2013**
(21) Application number: 12166993.1
(22) Date of filing: 07.05.2012
(51) Int. Cl.: H01L 21/306, H01L 21/02

(54) **A process for the manufacture of semiconductor devices comprising the chemical mechanical polishing (cmp) of iii-v material in the presence of a cmp composition comprising a compound containing an n-heterocycle**

(71) Applicant: BASF SE, 67056 Ludwigshafen (DE)
(72) Inventor: Franz, Diana, 67105 Schifferstadt (DE); Noller, Bastian Marten Dr., 64653 Lorsch (DE)

(57) **Abstract**

A process for the manufacture of semiconductor devices comprising the chemical-mechanical polishing of a substrate or layer containing at least one III-V material in the presence of a chemical-mechanical polishing composition (Q1) comprising
(A) inorganic particles, organic particles, or a mixture or composite thereof,
(B) a polymer comprising at least one N-heterocycle, and
(M) an aqueous medium.

## Description

### Field of the Invention

This invention essentially relates to a process for the manufacture of semiconductor devices comprising the chemical mechanical polishing (abbreviated as CMP in the following) of III-V material in the presence of a CMP composition comprising a specific compound containing an *N*-heterocycle, and its use in polishing substrates of the semiconductor industry which comprise III-V material.

### Description of the Prior Art

In the semiconductor industry, chemical mechanical polishing is a well-known technology applied in fabricating advanced photonic, microelectromechanical, and microelectronic materials and devices, such as semiconductor wafers.

During the fabrication of materials and devices used in the semiconductor industry, CMP is employed to planarize metal and/or oxide surfaces. CMP utilizes the interplay of chemical and mechanical action to achieve the planarity of the to-be-polished surfaces. Chemical action is provided by a chemical composition, also referred to as CMP composition or CMP slurry. Mechanical action is usually carried out by a polishing pad which is typically pressed onto the to-be-polished surface and mounted on a moving platen. The movement of the platen is usually linear, rotational or orbital.

In a typical CMP process step, a rotating wafer holder brings the to-be-polished wafer in contact with a polishing pad. The CMP composition is usually applied between the to-be-polished wafer and the polishing pad.

In the state of the art, CMP processes in the presence of a CMP composition comprising a polymer containing an *N*-heterocycle are known and described, for instance, in the following references.

EP 1757665 A1 discloses an aqueous dispersion for CMP useful for polishing metal films, comprising water, a polyvinylpyrrolidone (abbreviated as PVP in the following) having a weight-average molecular weight exceeding 200,000, an oxidant, abrasive grains, and a protective film-forming agent comprising (a) a first metal compound-forming agent which forms a water-insoluble metal compound, and (b) a second metal compound-forming agent which forms a water-soluble metal compound. The aqueous dispersion is capable of uniformly and stably polishing a metal film at low friction without causing defects in a metal film and an insulating film.

US 2007/176141 A1 discloses an aqueous composition useful for polishing silica and boro-phosphate-silicate-glass on a semiconductor wafer, comprising carboxylic acid polymer, abrasive, PVP, cationic compound, zwitterionic compound and water, wherein the PVP has an average molecular weight between 100 grams/mole to 1,000,000 grams/mole.

US 2006/138086 A1 discloses a method for polishing silica and silicon nitride on a semiconductor wafer comprising the steps of planarizing the silica with a first aqueous composition comprising carboxylic acid polymer, abrasive, PVP, cationic compound, phthalic acid and salts, zwitterionic compound and water, wherein the PVP has an average molecular weight between 100 grams/mole to 1,000,000 grams/mole.

US 2005/194562 A1 discloses a polishing composition suitable for polishing semiconductor substrates having a non-ferrous interconnect, comprising 0.001 to 2 wt % of a thermoplastic polymer, and 0.001 to 1 wt. % PVP; wherein varying the weight ratio of thermoplastic polymer to the PVP controls the removal rate of the non-ferrous interconnect. Examples for non-ferrous interconnects are aluminum, copper, gold, nickel, and platinum group metals, silver, tungsten and alloys comprising at least one of the foregoing metals.

In the state of the art, processes comprising the chemical mechanical polishing of a III-V material in the presence of a CMP composition comprising a nonpolymeric compound containing an *N*-heterocycle are known and described, for instance, in the following reference.

WO 2010/105240 A2 discloses a CMP slurry for gallium nitride comprising: at least about 80 wt% water; ultra-dispersed diamond (UDD) dispersed within the water, the UDD being present in an amount not greater than about 5 wt%; and a pH modifying agent in an amount effective to adjust the pH of the slurry to at least about 8.0. The slurry can optionally comprise a passivating agent such as 1,2,4-triazole. For example, the slurry is prepared by adding 0.2 wt% UDD, 2.5 wt% NaClO, 875 ppm citric acid, and 200 ppm 1,2,4-triazole to deionized water to form a slurry suitable for GaN polishing (Sample 7).

### Objects of the invention

One of the objects of the present invention was to provide a CMP composition and a CMP process appropriate for the chemical-mechanical polishing of III-V materials, particularly GaAs substrates, and showing an improved polishing performance, especially
(i) a high material removal rate (MRR) of the III-V material, for example GaAs,
(ii) a low static etch rate (SER) of the III-V material, for example GaAs,
(iii) high surface quality of the III-V material, for example GaAs, after the CMP step,
(iv) safe handling and reduction of hazardous by-products - for example the toxic gas AsH₃ in case of GaAs polishing - to a minimum, or
(v) or the combination of (i), (ii), (iii) and (iv).

Moreover, a CMP process was sought that is easy to apply and requires as few steps as possible.

### Summary of the invention

Accordingly, a process for the manufacture of semiconductor devices comprising the chemical-mechanical polishing of a substrate or layer containing at least one III-V material in the presence of a CMP composition (Q1) comprising
(A) inorganic particles, organic particles, or a mixture or composite thereof,
(B) at least one type of a polymer comprising at least one *N*-heterocycle, and
(M) an aqueous medium,
was found.

Moreover, the use of the CMP composition (Q1) for chemical-mechanical polishing of a substrate or layer containing at least one III-V material was found.

On the other hand, a process for the manufacture of semiconductor devices comprising the chemical-mechanical polishing of a substrate or layer containing at least one III-V material in the presence of a chemical-mechanical polishing composition (Q2) comprising
(A) inorganic particles selected from the group consisting of alumina, ceria, copper oxide, iron oxide, nickel oxide, manganese oxide, silica, silicon nitride, silicon carbide, tin oxide, titania, titanium carbide, tungsten oxide, yttrium oxide and zirconia, or organic particles, or a mixture or composite thereof,
(C) a non-polymeric compound comprising at least one *N*-heterocycle, and
(M) an aqueous medium,
was found.

Furthermore, the use of the CMP composition (Q2) for chemical-mechanical polishing of a substrate or layer containing at least one III-V material was found.

Preferred embodiments are explained in the claims and the specification. It is understood that combinations of preferred embodiments are within the scope of the present invention.

A semiconductor device can be manufactured by the process of the invention, said process comprises the chemical mechanical polishing of a substrate or layer - preferably a layer - containing at least one III-V material in the presence of the CMP composition (Q1) or (Q2). If the III-V material has the shape of a layer, the content of all III-V material contained in the layer is preferably more than 90%, more preferably more than 95%, most preferably more than 98%, particularly more than 99%, for example more than 99.9% by weight of the corresponding layer. A III-V material is a material consisting of at least one group 13 element (including Al, Ga, In) and at least one group 15 element (including N, P, As, Sb). The terms "group 13" and "group 15" refer to the current IUPAC convention for naming the groups in the periodic table of chemical elements. Preferably, said III-V material is GaN, GaP, GaAs, GaSb, AlAs, AIN, InP, InAs, InSb, InGaAs, InAlAs, AlGaAs, GaAlN, GaInN, InGaAlAs, InGaAsP, InGaP, AlInP, GaAlSb, GaInSb, GaAlAsSb, or GaInAsSb. More preferably, said III-V material is GaN, GaP, GaAs, GaSb, InP, InAs, InSb, InGaAs, or InAlAs. Most preferably, said III-V material is GaN, GaP, GaAs, GaAs, InP, or InAs. Particularly, said III-V material is GaAs (gallium arsenide).

The CMP composition (Q1) or (Q2) is used for chemical-mechanical polishing of a substrate or layer - preferably a layer - containing at least one III-V material, preferably for chemical-mechanical polishing of a layer containing at least one III-V material. If the III-V material has the shape of a layer, the content of all III-V material contained in the layer is preferably more than 90%, more preferably more than 95%, most preferably more than 98%, particularly more than 99%, for example more than 99.9% by weight of the corresponding layer. Preferably, said III-V material is GaN, GaP, GaAs, GaSb, AlAs, AIN, InP, InAs, InSb, InGaAs, InAlAs, AlGaAs, GaAlN, GaInN, InGaAlAs, InGaAsP, InGaP, AlInP, GaAlSb, GaInSb, GaAlAsSb, or GaInAsSb. More preferably, said III-V material is GaN, GaP, GaAs, GaSb, InP, InAs, InSb, InGaAs, or InA-IAs. Most preferably, said III-V material is GaN, GaP, GaAs, GaAs, InP, or InAs. Particularly, said III-V material is GaAs (gallium arsenide).

The CMP composition (Q1) comprises the components (A), (B), (M) and optionally further components as described below.

The CMP composition (Q2) comprises the components (A), (C), (M) and optionally further components as described below.

The CMP composition (Q1) or (Q2) comprises inorganic particles, organic particles, or a mixture or composite thereof (A). (A) can be
- of one type of inorganic particles,
- a mixture or composite of different types of inorganic particles,
- of one type of organic particles,
- a mixture or composite of different types of organic particles, or
- a mixture or composite of one or more types of inorganic particles and one or more types of organic particles.

A composite is a composite particle comprising two or more types of particles in such a way that they are mechanically, chemically or in another way bound to each other. An example for a composite is a core-shell particle comprising one type of particle in the outer sphere (shell) and another type of particle in the inner sphere (core).

Generally, the particles (A) can be contained in varying amounts in the CMP composition (Q1) or (Q2). Preferably, the amount of (A) is not more than 8 wt.% (wt.% stands for "percent by weight"), more preferably not more than5 wt.%, most preferably not more than 3.5 wt.%, particularly preferably not more than 2.5 wt.%, for example not more than 1.5 wt.%, based on the total weight of the composition (Q1) or (Q2). Preferably, the amount of (A) is at least 0.002 wt.%, more preferably at least 0.01 wt.%, most preferably at least 0.08 wt.%, particularly at least 0.4 wt.%, for example at least 1 wt.%, based on the total weight of the composition (Q1) or (Q2).

Generally, the particles (A) can be contained in varying particle size distributions. The particle size distributions of the particles (A) can be monomodal or multimodal. In case of multimodal particle size distributions, bimodal is often preferred. In order to have an easily reproducible property profile and easily reproducible conditions during the CMP process of the invention, a monomodal particle size distribution is preferred for (A). It is most preferred for (A) to have a monomodal particle size distribution.

The mean particle size of the particles (A) can vary within a wide range. The mean particle size is the d₅₀ value of the particle size distribution of (A) in the aqueous medium (M) and can be determined using dynamic light scattering techniques. Then, the d₅₀ values are calculated under the assumption that particles are essentially spherical. The width of the mean particle size distribution is the distance (given in units of the x-axis) between the two intersection points, where the particle size distribution curve crosses the 50% height of the relative particle counts, wherein the height of the maximal particle counts is standardized as 100% height.

Preferably, the mean particle size of the particles (A) is in the range of from 5 to 500 nm, more preferably in the range of from 10 to 400 nm, most preferably in the range of from 20 to 300 nm, in particular in the range of from 30 to 160 nm, for example in the range of from 35 to 135 nm, as measured with dynamic light scattering techniques using instruments such as High Performance Particle Sizer (HPPS) from Malvern Instruments, Ltd. or Horiba LB550.

The particles (A) can be of various shapes. Thereby, the particles (A) may be of one or essentially only one type of shape. However, it is also possible that the particles (A) have different shapes. For instance, two types of differently shaped particles (A) may be present. For example, (A) can have the shape of cubes, cubes with chamfered edges, octahedrons, icosahedrons, cocoons, nodules or spheres with or without protrusions or indentations. Preferably, they are spherical with no or only very few protrusions or indentations. According to another embodiment, they are preferably cocoon-shaped. Cocoon-shaped particles are particles with a minor axis of from 10 to 200 nm and ratio of major/minor axis of 1.4 to 2.2.

The chemical nature of particles (A) is not particularly limited. (A) may be of the same chemical nature or a mixture or composite of particles of different chemical nature. As a rule, particles (A) of the same chemical nature are preferred. Generally, (A) can be
- inorganic particles such as a metal, a metal oxide or carbide, including a metalloid, a metalloid oxide or carbide, or
- organic particles such as polymer particles,
- a mixture or composite of inorganic and organic particles.

If the process of the invention comprises the chemical-mechanical polishing in the presence of CMP composition (Q1) or if (Q1) is used, particles (A) are
- inorganic particles, organic particles, or a mixture or composite thereof,
- preferably inorganic particles, or a mixture or composite thereof,
- more preferably oxides and carbides of metals or metalloids, or a mixture or composite thereof,
- most preferably alumina, ceria, copper oxide, iron oxide, nickel oxide, manganese oxide, silica, silicon nitride, silicon carbide, tin oxide, titania, titanium carbide, tungsten oxide, yttrium oxide, zirconia, or a mixture or composites thereof,
- particularly preferably alumina, ceria, silica, titania, zirconia, or a mixture or composite thereof,
- in particular silica particles,
- for example colloidal silica particles.

If the process of the invention comprises the chemical-mechanical polishing in the presence of CMP composition (Q2) or if (Q2) is used, particles (A) are
- inorganic particles selected from the group consisting of alumina, ceria, copper oxide, iron oxide, nickel oxide, manganese oxide, silica, silicon nitride, silicon carbide, tin oxide, titania, titanium carbide, tungsten oxide, yttrium oxide and zirconia, organic particles, or a mixture or composite thereof,
- preferably inorganic particles selected from the group consisting of alumina, ceria, copper oxide, iron oxide, nickel oxide, manganese oxide, silica, silicon nitride, silicon carbide, tin oxide, titania, titanium carbide, tungsten oxide, yttrium oxide and zirconia, or a mixture or composite thereof,
- more preferably alumina, ceria, silica, titania, zirconia, or a mixture or composite thereof,
- most preferably silica particles,
- for example colloidal silica particles.

Typically, colloidal silica particles are produced by a wet precipitation process.

In another embodiment in which (A) are organic particles, or a mixture or composite of inorganic and organic particles, polymer particles are preferred as organic particles. Polymer particles can be homo- or copolymers. The latter may for example be block-copolymers, or statistical copolymers. The homo- or copolymers may have various structures, for instance linear, branched, comb-like, dendrimeric, entangled or cross-linked. The polymer particles may be obtained according to the anionic, cationic, controlled radical, free radical mechanism and by the process of suspension or emulsion polymerisation. Preferably, the polymer particles are at least one of the polystyrenes, polyesters, alkyd resins, polyurethanes, polylactones, polycarbonates, poylacrylates, polymethacrylates, polyethers, poly(N-alkylacrylamide)s, poly(methyl vinyl ether)s, or copolymers comprising at least one of vinylaromatic compounds, acrylates, methacrylates, maleic anhydride acrylamides, methacrylamides, acrylic acid, or methacrylic acid as monomeric units, or a mixture or composite thereof. Among them, polymer particles with a cross-linked structure are preferred.

The term "organic particles" denotes a compound in particle form whose molecules contain at least one carbon atom, except inorganic carbon-containing compounds which are:
- allotropes of carbon such as diamond, graphite and fullerene,
- carbon-containing alloys, or carbides,
- compounds whose carbon atom or atoms are all included in neutral molecules, ligands, or anions consisting only of
   (i1) at least one carbon atom and at least one atom of at least one Group 15, 16 and/or 17 element,
   (i2) hydrogen carbonate, carbonic acid, hydrogen thiocarbonate, or thiocarbonic acid, or
   (i3) HCN, H₂NCN, HOCN, HSCN, or isomers thereof.

The CMP composition (Q1) comprises a polymer (B) comprising at least one *N*-heterocycle. A polymer is any molecule composed of more than 10 repeating units. An *N-*heterocycle is a heterocycle containing at least one nitrogen atom as ring member atom.

The polymer (B) is preferably derived from at least one type of monomeric unit (MU) comprising at least one *N*-heterocycle, more preferably derived from one to two types of monomeric units (MU) comprising at least one *N*-heterocycle.

Said monomeric unit (MU) preferably comprises at least one *N-*heterocycle selected from the group consisting of pyrrole, pyrrolidine, pyrrolidone, imidazole, pyridine, pyrimidine, pyrazine, pyridazine, piperidine, triazole, benzotriazole, tetrazole, thiazole, isothiazole, thiazolidine, oxazole and isooxazole, more preferably comprises at least one *N*-heterocycle selected from the group consisting of pyrrole, pyrrolidine, pyrrolidone, imidazole, pyridine and pyrimidine, most preferably comprises a pyrrolidone or an imidazole.

Said monomeric unit (MU) preferably comprises at least one *N-*heterocycle substituted with an unsaturated hydrocarbon, more preferably comprises at least one alkene-substituted *N-*heterocycle, most preferably comprises a vinyl-substituted *N-*heterocycle, particularly preferably is a vinyl-substituted *N-*heterocycle.

The number of *N-*heterocycles comprised in said monomeric unit (MU) is preferably from 1 to 10, more preferably from 1 to 5, most preferably from 1 to 2, for example 1.

In particular, the polymer (B) is derived from one to two types of monomeric units (MU) comprising a pyrrolidone or imidazole, most preferably comprising a vinyl-substituted pyrrolidone or imidazole. For example, the polymer (B) is a polyvinylpyrrolidone polymer, a polyvinylimidazole polymer, or a vinylpyrrolidone / vinylimidazole copolymer.

In general, the *N*-heterocycle comprised in polymer (B) can be any *N-*heterocycle. The *N-*heterocycle comprised in polymer (B) is preferably pyrrole, pyrrolidine, pyrrolidone, imidazole, pyridine, pyrimidine, pyrazine, pyridazine, piperidine, triazole, benzotriazole, tetrazole, thiazole, isothiazole, thiazolidine, oxazole, or isooxazole, more preferably pyrrole, pyrrolidine, pyrrolidone, imidazole, pyridine, or pyrimidine, most preferably pyrrolidone or imidazole, in particular pyrrolidone, for example 2-pyrrolidone.

According to another embodiment, the *N-*heterocycle comprised in polymer (B) is a quaternary *N-*heterocycle, preferably an quaternary pyrrole, pyrrolidine, pyrrolidone, imidazole, pyridine, or pyrimidine, more preferably an quaternary imidazole. A quaternary *N*-heterocycle is an *N-*heterocycle in which one of the nitrogen ring member atoms is permanently positively charged, independent of the pH value of the solution.

According to another embodiment, the polymer (B) is preferably derived from at least one type of monomeric units (MU) comprising at least one quaternary *N-*heterocycle, more preferably derived from at least one type of monomeric units (MU) comprising an quaternary pyrrole, pyrrolidine, pyrrolidone, imidazole, pyridine, or pyrimidine, most preferably derived from at least one type of monomeric units (MU) comprising an quaternary imidazole, in particular, the polymer (B) is a quartenary polyvinylimidazole.

The polymer (B) can be contained in varying amounts in the CMP composition (Q1). Preferably, the amount of (B) is not more than 10 wt.%, more preferably not more than 3 wt.%, most preferably not more than 1 wt.%, particularly preferably not more than 0.5 wt.%, particularly not more than 0.2 wt.%, for example not more than 0.1 wt.%, based on the total weight of the composition (Q1). Preferably, the amount of (B) is at least 0.0001 wt.%, more preferably at least 0.001 wt.%, most preferably at least 0.008 wt.%, particularly preferably at least 0.02 wt.%, particularly at least 0.04 wt.%, for example at least 0.06 wt.%, based on the total weight of the composition (Q1).

Generally, the polymer (B) can have different weight average molecular weights. The weight average molecular weight of the polymer (B) is preferably at least 500, more preferably at least 2,000, most preferably at least 10,000, particularly at least 30,000, for example at least 40,000. The weight average molecular weight of (B) is preferably not more than 300,000, more preferably not more than 100,000, most preferably not more than 70,000, particularly not more than 50,000, for example not more than 40,000 [g/mol], as determined by gel permeation chromatography (abbreviated as "GPC" in the following). In particular, the weight average molecular weight of the polymer (B) is from 30,000 to 100,000 [g/mol] as determined by GPC. Said GPC are standard GPC techniques known to the person skilled of the art.

In general, the solubility of polymer (B) in an aqueous medium can vary within a wide range. The solubility of the polymer (B) in water at pH 7 at 25°C under atmospheric pressure is preferably at least 1 g/L, more preferably at least 5 g/L, most preferably at least 20 g/L, particularly at least 50 g/L, for example at least 150 g/L. Said solubility can be determined by evaporating the solvent and measuring the remaining mass in the saturated solution.

The CMP composition (Q2) comprises a non-polymeric compound (C) comprising at least one *N-*heterocycle. A non-polymeric compound is any molecule composed of not more than 10 repeating units. An *N*-heterocycle is a heterocycle containing at least one nitrogen atom as ring member atom.

In general, the *N-*heterocycle comprised in non-polymeric compound (C) can be any *N-*heterocycle. The *N-*heterocycle comprised in non-polymeric compound (C) is preferably an *N-*heterocycle which does not have more than two nitrogen atoms as ring member atoms, more preferably pyrrole, pyrrolidine, pyrrolidone, imidazole, pyridine, pyrimidine, pyrazine, pyridazine, piperidine, thiazole, isothiazole, thiazolidine, oxazole, or isooxazole, most preferably pyrrole, pyrrolidine, pyrrolidone, imidazole, pyridine, or pyrimidine, particularly preferably pyrrolidone or imidazole, in particular pyrrolidone, for example 2-pyrrolidone.

The number of *N-*heterocycles comprised in non-polymeric compound (C) is preferably from 1 to 10, more preferably from 1 to 5, most preferably from 1 to 2, for example 1.

The non-polymeric compound (C) is preferably an *N*-heterocycle which does not have more than two nitrogen atoms as ring member atoms, is more preferably pyrrole, pyrrolidine, pyrrolidone, imidazole, pyridine, pyrimidine, pyrazine, pyridazine, piperidine, thiazole, isothiazole, thiazolidine, oxazole, or isooxazole, and/or a derivative thereof, is most preferably pyrrole, pyrrolidine, pyrrolidone, imidazole, pyridine, or pyrimidine, and/or a derivative thereof, is particularly preferably pyrrolidone or imidazole, is in particular pyrrolidone, is for example 2-pyrrolidone.

The non-polymeric compound (C) can be contained in varying amounts in the CMP composition (Q2). Preferably, the amount of (C) is not more than 10 wt.%, more preferably not more than 3 wt.%, most preferably not more than 1.5 wt.%, particularly preferably not more than 0.8 wt.%, particularly not more than 0.4 wt.%, for example not more than 0.2 wt.%, based on the total weight of the composition (Q2). Preferably, the amount of (C) is at least 0.0001 wt.%, more preferably at least 0.001 wt.%, most preferably at least 0.01 wt.%, particularly preferably at least 0.03 wt.%, particularly at least 0.06 wt.%, for example at least 0.1 wt.%, based on the total weight of the composition (Q2).

In general, the solubility of non-polymeric compound (C) in an aqueous medium can vary within a wide range. The solubility of non-polymeric compound (C) in water at pH 7 at 25°C under atmospheric pressure is preferably at least 1 g/L, more preferably at least 5 g/L, most preferably at least 20 g/L, particularly at least 50 g/L, for example at least 150 g/L. Said solubility can be determined by evaporating the solvent and measuring the remaining mass in the saturated solution.

According to the invention, the CMP composition (Q1) or (Q2) contains an aqueous medium (M). (M) can be of one type or a mixture of different types of aqueous media.

In general, the aqueous medium (M) can be any medium which contains water. Preferably, the aqueous medium (M) is a mixture of water and an organic solvent miscible with water (e.g. an alcohol, preferably a C₁ to C₃ alcohol, or an alkylene glycol derivative). More preferably, the aqueous medium (M) is water. Most preferably, aqueous medium (M) is de-ionized water.

If the amounts of the components other than (M) are in total y % by weight of the CMP composition, then the amount of (M) is (100-y) % by weight of the CMP composition.

The CMP composition (Q1) or (Q2) can further optionally comprise at least one type of oxidizing agent (D), preferably one to two types of oxidizing agent (D), more preferably one type of oxidizing agent (D). In case of composition (Q1), the oxidizing agent (D) is different from the components (A) and (B). In case of composition (Q2), the oxidizing agent (D) is different from the components (A) and (C). In general, the oxidizing agent is a compound which is capable of oxidizing the to-be-polished substrate or one of its layers. Preferably, (D) is a per-type oxidizer. More preferably, (D) is a peroxide, persulfate, perchlorate, perbromate, periodate, permanganate, or a derivative thereof. Most preferably, (D) is a peroxide or persulfate. Particularly, (D) is a peroxide. For example, (D) is hydrogen peroxide.

If present, the oxidizing agent (D) can be contained in varying amounts in the CMP composition (Q1) or (Q2). Preferably, the amount of (D) is not more than 20 wt.%, more preferably not more than 10 wt.%, most preferably not more than 5 wt.%, particularly not more than 3.5 wt.%, for example not more than 2.7 wt.%, based on the total weight of the composition (Q1) or (Q2). Preferably, the amount of (D) is at least 0.01 wt.%, more preferably at least 0.08 wt.%, most preferably at least 0.4 wt.%, particularly at least 0.75 wt.%, for example at least 1 wt.%, based on the total weight of the composition (Q1) or (Q2). If hydrogen peroxide is used as oxidizing agent (D), the amount of (D) is preferably 1 wt.% to 5 wt.%, more preferably 2 wt.% to 3.5 wt.%, for instance 2.5 wt.%, based on the total weight of the composition (Q1) or (Q2).

The CMP composition (Q1) or (Q2) can further optionally contain at least one biocide (E), for example one biocide. In case of composition (Q1), the biocide (E) is different from the components (A) and (B). In case of composition (Q2), the biocide (E) is different from the components (A) and (C). In general, the biocide is a compound which deters, renders harmless, or exerts a controlling effect on any harmful organism by chemical or biological means. Preferably, (E) is an quaternary ammonium compound, an isothiazolinone-based compound, an *N*-substituted diazenium dioxide, or an *N*'-hydroxy-diazenium oxide salt. More preferably, (E) is an *N*-substituted diazenium dioxide, or an *N*'-hydroxy-diazenium oxide salt

If present, the biocide (E) can be contained in varying amounts. If present, the amount of (E) is preferably not more than 0.5 wt.%, more preferably not more than 0.1 wt.%, most preferably not more than 0.05 wt.%, particularly not more than 0.02 wt.%, for example not more than 0.008 wt.%, based on the total weight of the corresponding composition. If present, the amount of (E) is preferably at least 0.0001 wt.%, more preferably at least 0.0005 wt.%, most preferably at least 0.001 wt.%, particularly at least 0.003 wt.%, for example at least 0.006 wt.%, based on the total weight of the corresponding composition (Q1) or (Q2).

The CMP composition (Q1) or (Q2) can further optionally contain at least one corrosion inhibitor (F), for example one corrosion inhibitor. In case of composition (Q1), the corrosion inhibitor (F) is different from the components (A) and (B). In case of composition (Q2), the corrosion inhibitor (F) is different from the components (A) and (C). In general, all compounds forming a protective molecular layer on the surface of a III-V material - for example GaAs - can be used as corrosion inhibitor. Preferred corrosion inhibitors (F) are thiols, film forming polymers, and polyols. In case of composition (Q1), further preferred corrosion inhibitors (F) are diazoles, triazoles, tetrazoles, and their derivatives, for example benzotriazole or tolyltriazole.

If present, the corrosion inhibitor (F) can be contained in varying amounts. If present, the amount of (F) is preferably not more than 10 wt.%, more preferably not more than 2 wt.%, most preferably not more than 0.5 wt.%, particularly not more than 0.1 wt.%, for example not more than 0.05 wt.%, based on the total weight of the corresponding composition. If present, the amount of (F) is preferably at least 0.0005 wt.%, more preferably at least 0.005 wt.%, most preferably at least 0.025 wt.%, particularly at least 0.1 wt.%, for example at least 0.4 wt.%, based on the total weight of the corresponding composition (Q1) or (Q2).

The properties of the CMP composition (Q1) or (Q2), such as stability and polishing performance, may depend on the pH of the corresponding composition. Preferably, the pH value of the composition (Q1) or (Q2) is in the range of from 1.5 to 9, more preferably from 2 to 7, most preferably from 2.5 to 5.5, particularly preferably from 3 to 5, particularly from 3.5 to 4.5, for example from 3.8 to 4.2.

The CMP composition (Q1) or (Q2) can further optionally contain at least one pH adjusting agent (G). In case of composition (Q1), the pH adjusting agent (G) is different from the components (A) and (B). In case of composition (Q2), the pH adjusting agent (G) is different from the components (A) and (C). In general, the pH adjusting agent (G) is a compound which is added to the CMP composition (Q1) or (Q2) to have its pH value adjusted to the required value. Preferably, the CMP composition (Q1) or (Q2) contains at least one pH adjusting agent (G). Preferred pH adjusting agents are inorganic acids, carboxylic acids, amine bases, alkali hydroxides, ammonium hydroxides, including tetraalkylammonium hydroxides. For example, the pH adjusting agent (G) is nitric acid, sulfuric acid, ammonia, sodium hydroxide, or potassium hydroxide.

If present, the pH adjusting agent (G) can be contained in varying amounts. If present, the amount of (G) is preferably not more than 10 wt.%, more preferably not more than 2 wt.%, most preferably not more than 0.5 wt.%, particularly not more than 0.1 wt.%, for example not more than 0.05 wt.%, based on the total weight of the corresponding composition. If present, the amount of (G) is preferably at least 0.0005 wt.%, more preferably at least 0.005 wt.%, most preferably at least 0.025 wt.%, particularly at least 0.1 wt.%, for example at least 0.4 wt.%, based on the total weight of the corresponding composition (Q1) or (Q2).

The CMP composition (Q1) or (Q2) may also contain, if necessary, at least one other additive, including but not limited to stabilizers, surfactants, friction reducing agents, etc. In case of composition (Q1), said other additive is different from the components (A) and (B). In case of composition (Q2), said other additive is different from the components (A) and (C). Said other additives are for instance those commonly employed in CMP compositions and thus known to the person skilled in the art. Such addition can for example stabilize the dispersion, or improve the polishing performance, or the selectivity between different layers.

If present, said other additive can be contained in varying amounts. Preferably, the total amount of said other additives is not more than 10 wt.%, more preferably not more than 2 wt.%, most preferably not more than 0.5 wt.%, particularly not more than 0.1 wt.%, for example not more than 0.01 wt.%, based on the total weight of the corresponding CMP composition. Preferably, the total amount of said other additives is at least 0.0001 wt.%, more preferably at least 0.001 wt.%, most preferably at least 0.008 wt.%, particularly at least 0.05 wt.%, for example at least 0.3 wt.%, based on the total weight of the corresponding composition (Q1) or (Q2).

According to the preferred embodiment (PE1), a process for the manufacture of semiconductor devices comprising the chemical-mechanical polishing of a substrate or layer containing GaN, GaP, GaAs, GaSb, AlAs, AIN, InP, InAs, InSb, InGaAs, InAlAs, AlGaAs, GaAlN, GaInN, InGaAlAs, InGaAsP, InGaP, AlInP, GaAlSb, GaInSb, GaAlAsSb, or GaInAsSb was carried out in the presence of a CMP composition (Q1) comprising
(A) silica particles,
(B) a polymer comprising at least one *N-*heterocycle selected from the group consisting of pyrrole, pyrrolidine, pyrrolidone, imidazole, pyridine, and pyrimidine, and
(M) an aqueous medium.

According to the preferred embodiment (PE2), a process for the manufacture of semiconductor devices comprising the chemical-mechanical polishing of a substrate or layer containing GaAs was carried out in the presence of a CMP composition (Q1) comprising
(A) silica particles,
(B) a polymer comprising at least one *N-*heterocycle selected from the group consisting of pyrrole, pyrrolidine, pyrrolidone, imidazole, pyridine, pyrimidine, pyrazine, pyridazine, piperidine, triazole, benzotriazole, tetrazole, thiazole, isothiazole, thiazolidine, oxazole, and isooxazole, and
(M) an aqueous medium.

According to the preferred embodiment (PE3), a process for the manufacture of semiconductor devices comprising the chemical-mechanical polishing of a substrate or layer containing GaAs was carried out in the presence of a CMP composition (Q1) comprising
(A) inorganic particles, organic particles, or a mixture or composite thereof,
(B) a polymer which is derived from at least one type of monomeric unit (MU) comprising at least one *N*-heterocycle selected from the group consisting of pyrrole, pyrrolidine, pyrrolidone, imidazole, pyridine, and pyrimidine,
(D) an oxidizing agent, and
(M) an aqueous medium.

According to the preferred embodiment (PE4), a process for the manufacture of semiconductor devices comprising the chemical-mechanical polishing of a substrate or layer containing GaAs was carried out in the presence of a CMP composition (Q1) comprising
(A) silica particles,
(B) a polymer which is derived from at least one type of monomeric unit (MU) comprising a pyrrolidone or an imidazole,
(D) an oxidizing agent, and
(M) an aqueous medium.

According to the preferred embodiment (PE5), a process for the manufacture of semiconductor devices comprising the chemical-mechanical polishing of a substrate or layer containing GaAs was carried out in the presence of a CMP composition (Q1) comprising
(A) inorganic particles, organic particles, or a mixture or composite thereof,
(B) a polymer which is derived from at least one type of monomeric units (MU) comprising at least one quaternary *N-*heterocycle,
(D) an oxidizing agent, and
(M) an aqueous medium.

According to the preferred embodiment (PE6), a process for the manufacture of semiconductor devices comprising the chemical-mechanical polishing of a substrate or layer containing GaAs was carried out in the presence of a CMP composition (Q1) comprising
(A) silica particles,
(B) a polymer which is derived from at least one type of monomeric units (MU) comprising a quaternary imidazole,
(D) an oxidizing agent, and
(M) an aqueous medium.

According to the preferred embodiment (PE7), a process for the manufacture of semiconductor devices comprising the chemical-mechanical polishing of a substrate or layer GaN, GaP, GaAs, GaSb, AlAs, AIN, InP, InAs, InSb, InGaAs, InAlAs, AlGaAs, GaAlN, GaInN, InGaAlAs, InGaAsP, InGaP, AlInP, GaAlSb, GaInSb, GaAlAsSb, or GaInAsSb was carried out in the presence of a CMP composition (Q2) comprising
(A) silica particles,
(C) a non-polymeric compound comprising at least one *N*-heterocycle selected from the group consisting of pyrrole, pyrrolidine, pyrrolidone, imidazole, pyridine, and pyrimidine, and
(M) an aqueous medium.

According to the preferred embodiment (PE8), a process for the manufacture of semiconductor devices comprising the chemical-mechanical polishing of a substrate or layer containing GaAs was carried out in the presence of a CMP composition (Q2) comprising
(A) silica particles,
(C) a non-polymeric compound comprising at least one *N-*heterocycle which does not have more than two nitrogen atoms as ring member atoms, and
(M) an aqueous medium.

According to the preferred embodiment (PE9), a process for the manufacture of semiconductor devices comprising the chemical-mechanical polishing of a substrate or layer containing GaAs was carried out in the presence of a CMP composition (Q2) comprising
(A) inorganic particles selected from the group consisting of alumina, ceria, copper oxide, iron oxide, nickel oxide, manganese oxide, silica, silicon nitride, silicon carbide, tin oxide, titania, titanium carbide, tungsten oxide, yttrium oxide and zirconia, or organic particles, or a mixture or composite thereof,
(C) pyrrolidone,
(D) an oxidizing agent, and
(M) an aqueous medium.

According to the preferred embodiment (PE10), a process for the manufacture of semiconductor devices comprising the chemical-mechanical polishing of a substrate or layer containing GaAs was carried out in the presence of a CMP composition (Q2) comprising
(A) silica particles,
(C) pyrrolidone,
(D) an oxidizing agent, and
(M) an aqueous medium.

Processes for preparing CMP compositions are generally known. These processes may be applied to the preparation of the CMP composition (Q1) or (Q2). This can be carried out by dispersing or dissolving the above-described components (A), (B), or (C) in the aqueous medium (M), preferably water, and optionally by adjusting the pH value through adding an acid, a base, a buffer or an pH adjusting agent. For this purpose the customary and standard mixing processes and mixing apparatuses such as agitated vessels, high shear impellers, ultrasonic mixers, homogenizer nozzles or counterflow mixers, can be used.

The CMP composition (Q1) is preferably prepared by dispersing the particles (A), dispersing and/or dissolving the polymer (B) and optionally other additives in the aqueous medium (M).

The CMP composition (Q2) is preferably prepared by dispersing the particles (A), dispersing and/or dissolving the non-polymeric compound (C) and optionally other additives in the aqueous medium (M).

The polishing process is generally known and can be carried out with the processes and the equipment under the conditions customarily used for the CMP in the fabrication of wafers with integrated circuits. There is no restriction on the equipment with which the polishing process can be carried out.

As is known in the art, typical equipment for the CMP process consists of a rotating platen which is covered with a polishing pad. Also orbital polishers have been used. The wafer is mounted on a carrier or chuck. The side of the wafer being processed is facing the polishing pad (single side polishing process). A retaining ring secures the wafer in the horizontal position.

Below the carrier, the larger diameter platen is also generally horizontally positioned and presents a surface parallel to that of the wafer to be polished. The polishing pad on the platen contacts the wafer surface during the planarization process.

To produce material loss, the wafer is pressed onto the polishing pad. Both the carrier and the platen are usually caused to rotate around their respective shafts extending perpendicular from the carrier and the platen. The rotating carrier shaft may remain fixed in position relative to the rotating platen or may oscillate horizontally relative to the platen. The direction of rotation of the carrier is typically, though not necessarily, the same as that of the platen. The speeds of rotation for the carrier and the platen are generally, though not necessarily, set at different values. During the CMP process of the invention, the CMP composition (Q1) or (Q2) is usually applied onto the polishing pad as a continuous stream or in dropwise fashion. Customarily, the temperature of the platen is set at temperatures of from 10 to 70°C.

The load on the wafer can be applied by a flat plate made of steel for example, covered with a soft pad that is often called backing film. If more advanced equipment is being used a flexible membrane that is loaded with air or nitrogen pressure presses the wafer onto the pad. Such a membrane carrier is preferred for low down force processes when a hard polishing pad is used, because the down pressure distribution on the wafer is more uniform compared to that of a carrier with a hard platen design. Carriers with the option to control the pressure distribution on the wafer may also be used according to the invention. They are usually designed with a number of different chambers that can be loaded to a certain degree independently from each other.

For further details reference is made to WO 2004/063301 A1, in particular page 16, paragraph [0036] to page 18, paragraph [0040] in conjunction with the figure 2.

By way of the CMP process of the invention, wafers with integrated circuits comprising a dielectric layer can be obtained which have an excellent functionality.

The CMP composition (Q1) or (Q2) can be used in the CMP process as ready-to-use slurry, they have a long shelf-life and show a stable particle size distribution over long time. Thus, they are easy to handle and to store. They show an excellent polishing performance, particularly with regard to the high surface quality combined with minimal generation of the toxic gas AsH3. Since the amounts of its components are held down to a minimum, the CMP composition (Q1) or (Q2) and the CMP process according to the invention can be used or applied in a cost-effective way.

### Examples and Comparative Examples

### General procedure for the CMP experiments

For the evaluation on benchtop polisher, the following parameters were chosen:
Procedure setting: Phoenix 4000 polisher; table/carrier 200/150rpm; down force 2.5 psi (17238 Pa); slurry flow rate 18mL/min; pad IC 1000; time 1 min.

The pad is conditioned by several sweeps, before a new type of CMP composition is used for CMP. For the determination of removal rates at least 3 wafers are polished and the data obtained from these experiments are averaged.

The CMP composition is stirred in the local supply station.

### Object to be polished: unstructured GaAs wafer

The GaAs material removal rates (referred to as "GaAs-MRR" in the following) for 2 inch (=5.08 cm) discs polished by the CMP composition are determined by difference of weight of the coated wafers or blanket discs before and after CMP, using a Sartorius LA310 S scale. The difference of weight can be converted into the difference of film thickness since the density (5.32 g/cm³ for GaAs) and the surface area of the polished material are known. Dividing the difference of film thickness by the polishing time provides the values of the material removal rate.

The hot static etching rate of the GaAs layer (referred to as "GaAs-hSER" in the following) is determined by dipping 1x1 inch (2.54 x 2.54 cm) GaAs coupon into the corresponding composition for 5 minutes at 60°C and measuring the loss of mass before and after the dipping.

The GaAs surface quality, i.e. the surface quality of GaAs layers after the CMP step, were determined from microscopic images.

The amount of generated AsH₃ gas was determined by a mobile hydride detector from the company Dräger, which was mouted 10 cm above the polishing pad. The device has a digital display showing the current concentration of AsH3 in the atmosphere.

Silica particles used as particles (A) are of NexSil™ (Nyacol) type. NexSil™ 125K are potassium-stabilized colloidal silica having a typical particle size of 85 nm and a typical surface area of 35 m²/g.

Sokalan HP56K (from BASF SE) is a 30% solution of vinylpyrrolidone / vinylimidazole copolymer having a weight average molecular weight of 70,000 [g/mol], wherein the viscosity of the solution is 300 mPa · s.

Sokalan HP66K (from BASF SE) is a 41 % solution of modified vinylpyrrolidone / vinylimidazole copolymer, wherein the viscosity of the solution is 2000 mPa · s.

Sokalan HP165 (from BASF SE) is a 30% solution of polyvinylpyrrolidone having a weight average molecular weight of 9,000 [g/mol], wherein the viscosity of the solution is 20 mPa · s.

Basotronic PVI (from BASF SE) is a 43-45% solution of quaternary polyvinylimidazole, wherein the viscosity of the solution is 40-80 mPa · s.

### Standard procedure for slurry preparation:

The components (A), (B) or (C), and (D) - each in the amounts as indicated in Table 1 - were dispersed or dissolved in de-ionized water. pH is adjusted by adding of aqueous 10% KOH solution or HNO₃ (0.1 % - 10 %) solution to the slurry. The pH value is measured with a pH electrode (Schott, blue line, pH 0-14 / -5...100 °C / 3 mol/L sodium chloride).

### Examples 1 to 9 (Compositions used in the process of the invention) and Comparative Example V1 (comparative composition)

An aqueous dispersion containing the components as listed in Table 1 was prepared, furnishing the CMP compositions of the examples 1 to 9 and the comparative example V1.

The formulation and polishing performance data and of the CMP compositions of the examples 1 to 9 and of the comparative example V1 are indicated in the Table 1:

**Table 1: CMP compositions of the examples 1 to 9 and of the comparative example V1, their pH values, GaAs-hSER data as well as their GaAs-MRR in the process of chemical-mechanical polishing of 2 inch (=5.08 cm) unstructured GaAs wafers using these compositions, wherein the aqueous medium (M) of the CMP compositions is de-ionized water. The amounts of the components (A), (B), (C) and (D) are specified in weight percent (wt.%) by weight of the corresponding CMP composition. If the amounts of the components other than (M) are in total y % by weight of the CMP composition, then the amount of (M) is (100-y) % by weight of the CMP composition.**

| | Comparative Example V1 | Example 1 | Example 2 | Example 3 | Example 4 |
|---|---|---|---|---|---|
| Particles (A) | NexSil™ | NexSil™ | NexSil™ | NexSil™ | NexSil™ |
| | 125K | 125K | 125K | 125K | 125K |
| | 3.0 wt. % | 3.0 wt. % | 3.0 wt. % | 3.0 wt. % | 3.0 wt. % |
| Polymer (B) | - | Sokalan | Sokalan | Sokalan | Sokalan |
| | | HP56K | HP56K | HP56K | HP66K |
| | | 0.1 wt.% | 0.2 wt. % | 0.3 wt. % | 0.2 wt. % |
| Non-polymeric compound (C) | - | - | - | - | - |
| Oxidizing agent (D) | H₂O₂ | H₂O₂ | H₂O₂ | H₂O₂ | H₂O₂ |
| | 2.5 wt. % | 2.5 wt. % | 2.5 wt. % | 2.5 wt. % | 2.5 wt. % |
| pH | 4 | 4 | 4 | 4 | 4 |
| GaAs-MRR [Å/min] | 4456 | 3258 | 2511 | 1395 | 1643 |
| GaAs-hSER [Å/min] | 66 | 25 | 16 | 13 | 7 |
| AsH₃ generation [ppm] | 0.09 | Not determined | 0.04 | Not determined | 0.04 |
| GaAs surface quality | Slightly rough | Not determined | shiny | Not determined | Slightly dull |

| | Example 5 | Example 6 | Example 7 | Example 8 | Example 9 |
|---|---|---|---|---|---|
| Particles (A) | NexSil™ | NexSil™ | NexSil™ | NexSil™ | NexSil™ |
| | 125K | 125K | 125K | 125K | 125K |
| | 3.0 wt. % | 3.0 wt. % | 3.0 wt. % | 3.0 wt. % | 3.0 wt. % |
| Polymer (B) | Sokalan | Basotronic | - | - | - |
| | HP165 | PVI | | | |
| | 0.2 wt. % | 0.2 wt. % | | | |
| Non-polymeric compound (C) | - | - | 1,2,4-triazole | Benzo-triazole | 2-pyrrolidone (Soluphor P from BASF SE) |
| | | | 0.2 wt. % | 0.2 wt. % | |
| | | | | | 0.2 wt. % |
| Oxidizing agent (D) | H₂O₂ | H₂O₂ | H₂O₂ | H₂O₂ | H₂O₂ |
| | 2.5 wt. % | 2.5 wt. % | 2.5 wt. % | 2.5 wt. % | 2.5 wt. % |
| pH | 4 | 4 | 4 | 4 | 4 |
| GaAs-MRR [Å/min] | 2107 | 2325 | 2669 | 3421 | 4321 |
| GaAs-hSER [Å/min] | 12 | 18 | 0 | 21 | 17 |
| AsH₃ generation [ppm] | 0.03 | 0.03 | 0.06 | 0.05 | 0.05 |
| GaAs surface quality | dull | Slightly dull | Slightly dull | Slightly dull | Not determined |

The CMP processes of the invention using these examples of CMP compositions show an improved polishing performance.

## Claims

1. A process for the manufacture of semiconductor devices comprising the chemical-mechanical polishing of a substrate or layer containing at least one III-V material
in the presence of a chemical-mechanical polishing composition (Q1) comprising
(A) inorganic particles, organic particles, or a mixture or composite thereof,
(B) a polymer comprising at least one *N*-heterocycle, and
(M)an aqueous medium.

2. A process according to claim 1, wherein the III-V material is GaN, GaP, GaAs, GaSb, AlAs, AIN, InP, InAs, InSb, InGaAs, InAlAs, AlGaAs, GaAlN, GaInN, InGaAlAs, InGaAsP, InGaP, AlInP, GaAlSb, GaInSb, GaAlAsSb, or GaInAsSb.

3. A process according to claim 1, wherein the III-V material is GaAs.

4. A process according to anyone of the claims 1 to 3, wherein the polymer (B) is derived from at least one type of monomeric unit (MU) comprising at least one *N-*heterocycle.

5. A process according to anyone of the claims 1 to 4, wherein the *N*-heterocycle is pyrrole, pyrrolidine, pyrrolidone, imidazole, pyridine, pyrimidine, pyrazine, pyridazine, piperidine, triazole, benzotriazole, tetrazole, thiazole, isothiazole, thiazolidine, oxazole, or isooxazole.

6. A process according to anyone of the claims 1 to 5, wherein the *N*-heterocycle is pyrrolidone or imidazole.

7. A process according to anyone of the claims 1 to 6, wherein the polymer (B) is a polyvinylpyrrolidone polymer, a polyvinylimidazole polymer, or a vinylpyrrolidone /vinylimidazole copolymer.

8. A process according to anyone of the claims 1 to 7, wherein the composition (Q1) further comprises (D)at least one type of an oxidizing agent.

9. A process according to anyone of the claims 1 to 8, wherein the particles (A) are silica particles.

10. A process according to anyone of the claims 1 to 9, wherein the III-V material is GaAs and wherein the composition (Q1) comprises
(A) silica particles,
(B) a polymer which is derived from at least one type of monomeric unit (MU) comprising a pyrrolidone or an imidazole,
(D)an oxidizing agent, and
(M)an aqueous medium.

11. Use of the chemical-mechanical polishing composition (Q1) comprising
(A) inorganic particles, organic particles, or a mixture or composite thereof,
(B) at least one type of a polymer comprising at least one *N*-heterocycle, and
(M)an aqueous medium
for chemical-mechanical polishing of a substrate or layer containing at least one III-V material.

12. A process for the manufacture of semiconductor devices comprising the chemical-mechanical polishing of a substrate or layer containing at least one III-V material
in the presence of a chemical-mechanical polishing composition (Q2) comprising
(A) inorganic particles selected from the group consisting of alumina, ceria, copper oxide, iron oxide, nickel oxide, manganese oxide, silica, silicon nitride, silicon carbide, tin oxide, titania, titanium carbide, tungsten oxide, yttrium oxide and zirconia, or organic particles, or a mixture or composite thereof,
(C)a non-polymeric compound comprising at least one *N*-heterocycle, and
(M)an aqueous medium.

13. A process according to claim 12, wherein the *N*-heterocycle does not have more than two nitrogen atoms as ring member atoms.

14. A process according to claim 12 or 13, wherein the III-V material is GaAs and wherein the composition (Q2) comprises
(A) silica particles,
(C) pyrrolidone,
(D)an oxidizing agent, and
(M)an aqueous medium.

15. Use of the chemical-mechanical polishing composition (Q2) comprising
(A) inorganic particles selected from the group consisting of alumina, ceria, copper oxide, iron oxide, nickel oxide, manganese oxide, silica, silicon nitride, silicon carbide, tin oxide, titania, titanium carbide, tungsten oxide, yttrium oxide and zirconia, or organic particles, or a mixture or composite thereof,
(C)a non-polymeric compound comprising at least one *N*-heterocycle, and
(M)an aqueous medium
for chemical-mechanical polishing of a substrate or layer containing at least one III-V material.
